**Europäisches Patentamt**

(19) **European Patent Office**

**Office européen des brevets**

(11) Numéro de publication: **0 006 039**
**B1**

(12) **FASCICULE DE BREVET EUROPEEN**

(45) Date de publication du fascicule de brevet:
**31.03.82**

(21) Numéro de dépôt: **79400261.8**

(22) Date de dépôt: **24.04.79**

(51) Int. Cl.³: **H 05 K 3/36, H 05 K 7/06,**
**H 01 R 35/00, H 01 B 7/08**

(54) Procédé de raccordement de bornes de connexion d'ensembles électriques.

(30) Priorité: **28.04.78 FR 7812698**

(43) Date de publication de la demande:
**12.12.79 Bulletin 79/25**

(45) Mention de la délivrance du brevet:
**31.03.82 Bulletin 82/13**

(84) Etats contractants désignés:
**CH DE GB IT NL**

(56) Documents cités:
**FR-A-1 440 211**
**FR-A-2 080 918**
**FR-A-2 084 258**
**FR-A-2 099 091**
**FR-A-2 111 979**
**FR-A-2 247 048**
**US-A-3 184 699**
**US-A-3 421 961**
**US-A-4 000 558**
**IBM TECHNICAL DISCLOSURE BULLETIN**
**vol. 20, nr. 9, février 1978, New York (US)**
**G. G. HOPKINS et al., »Flexible cable fabrication**
**and termination process«, pages 3379 et 3380**

(73) Titulaire: **COMMISSARIAT A L'ENERGIE ATOMIQUE**
**Etablissement de Caractère Scientifique Technique et**
**Industriel, B.P. 510, F-75752 Paris Cedex 15 (FR)**

(72) Inventeur: **Campillo, Louis, 15, rue Henri Coeur,**
**F-38420 Domene (FR)**
Inventeur: **Nicolas, Gérard, "Les Tilleuls",**
**F-38340 Voreppe (FR)**

(74) Mandataire: **Mongrédien, André et al, c/o**
**Brevatome 25, rue de Ponthieu, F-75008 Paris (FR)**

## Procédé de raccordement de bornes de connexion d'ensembles électriques

La présente invention a pour objet un procédé de raccordement entre elles de bornes de connexion d'ensembles électriques.

De façon plus précise, la présente invention a pour objet un procédé qui permet de raccorder les bornes d'entrée ou de sortie de deux dispositifs électriques A et B par l'intermédiaire de liaisons électriques quelle que soit la disposition de ces deux ensembles l'un par rapport à l'autre et quel que soit l'écartement entre les différents contacts de ces bornes.

On sait que dans le domaine des circuits électriques ou électroniques, il se présente souvent le problème du raccordement de deux ensembles A et B par des liaisons électriques. En règle générale, l'ensemble A comporte, par exemple, un connecteur de sortie et l'ensemble B un connecteur d'entrée. Chacun de ces connexteurs comporte, par exemple n bornes et il s'agit de relier par un conducteur électrique chaque borne du connecteur de sortie de l'ensemble A à la borne correspondante du connexteur d'entrée du dispositif B. Compte tenu de l'évolution des circuits électriques et surtout électroniques, et en particulier de l'augmentation de leur densité, les différentes bornes d'un tel connecteur à la sortie d'un ensemble électrique ou électronique sont très rapprochées. Dans la suite de la description on appellera »pas« l'écartement entre deux bornes adjacentes. Dans le cas où ce pas est faible, par exemple inférieur au millimètre, les techniques habituelles d'interconnexion ne sont plus applicables, compte tenu de la densité des connexions à effectuer.

Il est bien connu, dans le cas des circuits électroniques, d'utiliser, pour réaliser ces connexions, des circuits imprimés à haute densité de ligne de connexion qui sont déposés et gravés sur des supports souples. Les inconvénients de ces circuits imprimés sont bien connus surtout lorsque la densité d'implantation de ces connexions est élevée. On peut citer les problèmes d'isolation et de coupure lors de la gravure de ces liaisons électriques.

On sait également qu'on dispose, pour réaliser ces interconnexions, de supports souples appelés encore »limandes«. Sur ces ensembles d'interconnexions les conducteurs sont ronds, plats ou à sections rectangulaires, et régulièrement espacés les uns des autres, par fils ou par groupes de fils. Ces conducteurs sont enrobés dans un isolant plastique de façon à constituer le câble plat désiré. L'utilisation de ces produits ne permet pas de résoudre les cas de connexion dans lesquels les distances entre fils sont inférieures à 1,27 m·n. Par ailleurs, ils s'adaptent généralement à des pièces standard appelées connecteurs comprenant des parties mécaniques mâles et femelles.

On peut résumer les problèmes que pose l'utilisation de ces »limandes« en disant que ces »limandes« du commerce réunissent un connecteur à un autre connecteur.

La présente invention a précisément pour objet un procédé d'interconnexion de deux ensembles électriques comportant chacun n bornes d'entrée ou de sortie par des fils conducteurs, procédé qui permet d'obtenir une haute densité de connexion et qui est en particulier utilisable lorsque le pas entre les différentes bornes de connexion est très réduit, par exemple de l'ordre de quelques dixièmes de millimètre.

Le procédé de connexion de deux ensembles présentant chacun n bornes de connexion à l'aide de liaisons conductrices, les bornes de connexion de l'un au moins desdits ensembles se présentant sous forme de zones conductrices affleurant à la surface extérieure du support de cet ensemble, se caractérise en ce que:

— on définit un support isolant souple ayant deux extrémités de connexion et une partie centrale, l'une au moins des extrémités de connexion comprenant au moins un évidement, le ou les évidements étant aptes à se superposer aux bornes de l'ensemble correspondant, ledit support souple comportant au moins un prolongement disposé au-delà dudit évidement ou de chacun desdits évidements par rapport à ladite partie centrale;
— on déroule et on colle sur ledit support souple, y compris sur le ou lesdits prolongements n liaisons électriques, une des extrémités de chaque liaison étant ainsi disposée au-dessus d'un évidement au droit de la borne auquel il doit être connecté, et
— on assure le contact électrique entre chaque extrémité des liaisons électriques et on supprime le ou lesdits prolongements, ledit procédé comportant en outre l'étape de coller lesdites extrémités du support souple sur lesdits ensembles.

Selon un premier mode de mise en œuvre plus adapté au cas où le pas entre les bornes est supérieur à 0,5 mm environ, on colle lesdites liaisons électriques sur ledit support souple et ensuite, on colle les extrémités dudit support souple sur les supports desdits ensembles.

Selon un deuxième mode de mise en œuvre plus adapté au cas inverse, on colle lesdites extrémités du support souple sur les supports desdits ensembles de telle façon que le ou lesdits évidements soient disposés au droit desdites bornes, et ensuite, on colle lesdites liaisons électriques sur ledit support souple.

On voit cependant que dans les deux cas, à la fin du procédé objet de l'invention, le support souple est collé par ses extrémités sur les deux ensembles à relier électriquement.

De toute façon, l'invention sera mieux comprise à la lecture de la description qui suit de plusieurs modes de mise en œuvre de procédé objet de l'invention, donnés à titre d'exemples non limitatifs. La description se réfère aux figures annexées sur lesquelles on a représenté:

— sur la fig. 1, une vue générale montrant deux ensembles électriques A et B reliés par des connexions électriques, cette figure ayant pour but d'exposer le problème à résoudre;
— sur les fig. 2a à 2c, les différentes étapes du procédé de connexion selon l'invention dans le cas où le pas des bornes de connexion est supérieur à 0,5 mm;
— sur la fig. 3, un exemple d'utilisation du procédé de connexion au cas d'un imageur à cristaux liquides, et
— sur la fig. 4, une vue en coupe transversale montrant la liaison entre un fil conducteur et une borne de connexteur.

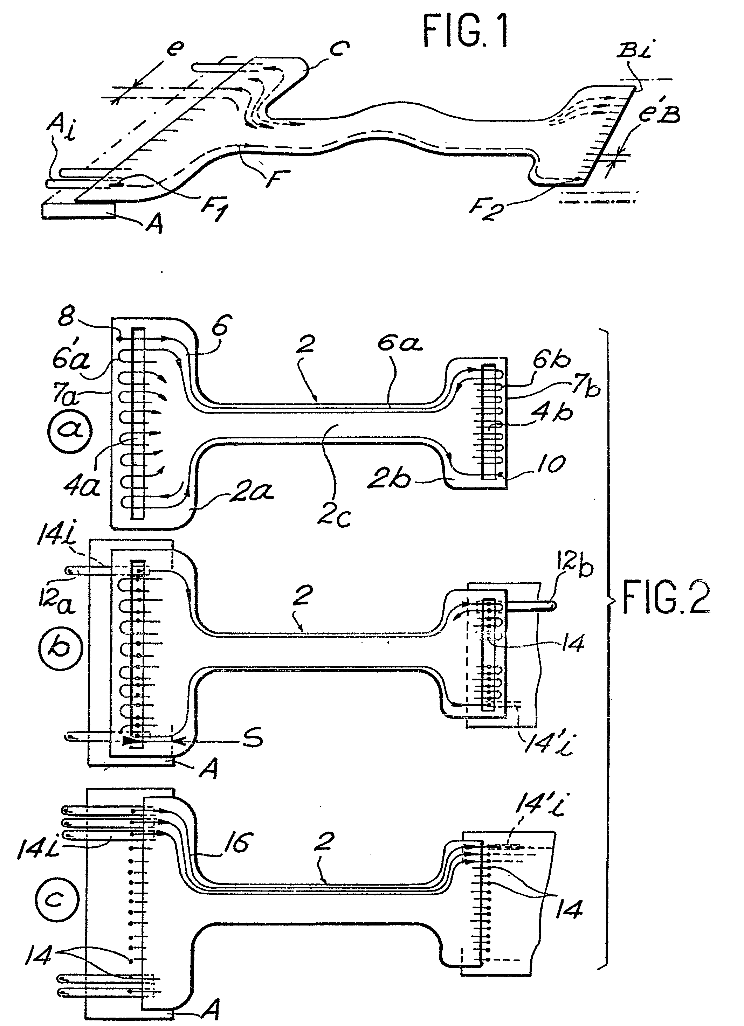

Sur la fig. 1, on a représenté le type de connexion qui permet d'obtenir le procédé objet de l'invention. Il s'agit de relier le premier circuit A au deuxième circuit B. Le circuit A comporte des bornes de sorties $A_i$ qui sont régulièrement disposées avec un pas e. De même, le deuxième circuit B comporte des bornes d'entrée $B_i$ qui sont régulièrement disposées avec un pas e'. Le procédé objet de l'invention permet d'assurer la connexion entre une borne $A_i$ du circuit A et la borne correspondante $B_i$ du circuit B. L'ensemble des connexions est constitué par un support souple isolant C et par des fils F isolés ou non qui sont collés sur ce support. Une première extrémité $F_1$ de chaque fil F est connectée à une borne $A_i$ de l'ensemble A et la deuxième extrémité $F_2$ du même fil est connectée à la borne $B_i$ de l'ensemble B. La plaque isolante souple C a la forme générale d'un convergent-divergent. La plaque C est collée à ses extrémités sur les plaques support des ensembles électriques A et B. On obtient ainsi une liaison entre les ensembles A et B.

Après avoir défini le résultat que permet d'obtenir le procédé, on va décrire en détail les différentes étapes d'un mode préféré de mise en œuvre du procédé dans le cas où le pas le plus faible entre les bornes de connexion est supérieur à 0,5 mm.

Dans un premier temps, on découpe un support souple et isolant 2 qui comporte une première extrémité de connexion 2a et une deuxième extrémité de connexion 2b raccordées par une portion de largeur réduite 2c. L'extrémité de connexion 2a comporte un évidement 4a de forme générale rectangulaire dont les dimensions sont aptes à recouvrir l'ensemble des bornes de connexion de l'ensemble électrique A, supposées alignées. De même, l'extrémité de connexion 2b comporte un évidement de forme générale rectangulaire 4b apte à recouvrir l'ensemble des bornes de connexion de l'ensemble électrique B, également supposées alignées. On voit que les évidements 4a et 4b définissent par rapport à la partie centrale 2c du support souple 2 des prolongements 7b et 7a rattachés au reste du support par les pattes entourant les évidements. Dans une deuxième étape, on déroule et on colle un fil conducteur 6 de façon continue sur le support souple 2. Ce fil a bien sûr la section voulue et, selon la densité des connexions réalisées, il peut être isolé ou non. Le collage de ce fil 6 sur le support souple isolant 2 est réalisé à l'aide d'une machine programmée qui est identique à celle qui a été décrite dans le brevet français déposé au nom de la demanderesse sous le n° 2 185 915, le fil qui est continu forme un serpentin qui comporte des portions telles que 6a qui constitueront les liaisons électriques définitives et des boucles 6b et 6'a qui vont au-delà respectivement des évidements 4a et 4b, et qui sont ainsi collés sur les prolongements 7a et 7b. Du fait que le fil conducteur est collé de part et d'autre de chaque évidement, le collage est aisé et on obtient un très bon positionnement des portions du fil conducteur disposées au-dessus des évidements 4a et 4b. En d'autres termes, le fil 6 continu comporte une première extrémité 8 qui, dans l'exemple décrit, est collée sur le prolongement 7a de l'extrémité de connexion 2a et une deuxième extrémité 10 collée sur le prolongement 7b de l'extrémité de connexion 2b. Selon la densité de connexion nécessaire, le fil 6 peut être isolé ou non. Dans le cas où le fil 6 est isolé, en plus de l'opération de collage du fil 6 sur le support souple 2, la machine réalise le dénudage du fil au droit des évidements 4a et 4b.

Une fois que le structure, constituée par le support souple 2 et le fil 6 continu, est réalisée, on vient placer cet ensemble sur les éléments de circuits à assembler et qui portent toujours les références A et B.

On positionne les ensembles électriques A et B avec un écartement correct et on vient superposer, à ces ensembles A et B, le support souple 2 de telle façon que les bornes de connexion 12a du circuit A et 12b du circuit B soient en regard des différents méandres du fil conducteur 6 et que ces bornes soient disposées en-dessous des évidements 4. On colle le support souple 2 sur les supports des ensembles électriques A et B sur une largeur s de telle façon que les encoches 4a et 4b soient sensiblement au ras de la zone de collage d'épaisseur s. Dans un deuxième temps, on réalise n points de contact électrique tels que 14 qui assurent la liaison électrique entre chacune des bornes 12a et chacune des portions de fil 6 disposées au-dessus de l'évidement 4a d'une part, et entre les bornes 12b et les portions de fils disposées au-dessus de l'évidement 4b, d'autre part. On comprend que, d'une part, à la suite de cette opération, on a solidarisé le support souple 2 avec les supports correspondant au circuit A et au circuit B et que d'autre part, on a assuré la liaison électrique entre les bornes 12a et 12b et les différentes liaisons électriques réalisées sur le support souple 2. Dans une dernière étape, on vient, d'une part, couper le support souple dans les prolongements 7a et 7b des évidements 4a et 4b, et, d'autre part, on coupe les boucles 6'a et 6b du fil continu 6 au-delà des points de contact électrique. Comme on le voit sur la fig. 2c, on obtient donc ainsi une succession de fils de connexion 16 reliant une borne 14$_i$ du circuit A à la borne 14'$_i$ du circuit B. On comprend également que, compte tenu du fait que le support 2 est souple, il n'est nullement nécessaire que les circuits A et B soient disposés dans un même plan. On voit par ailleurs que le collage du fil sur le support souple 2 est aisé du fait qu'un fil conducteur continu 6 est mis en place, la séparation de ce fil en un faisceau convergent-divergent de conducteurs individuels 16 n'étant réalisée qu'ultérieurement par la découpe des boucles 6'a et 6b et des extrémités du support souple 2. Bien entendu, on pourrait coller successivement chacune des liaisons électriques 16.

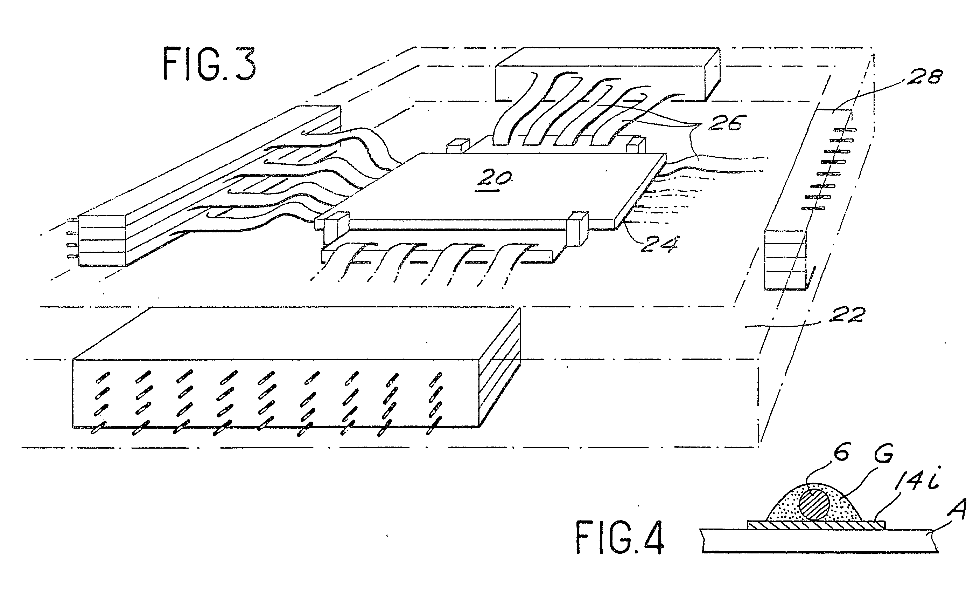

Sur la fig. 4, on a représenté un mode de réalisation de la liaison entre une borne 14$_i$ et un fil conducteur 6. Le fil 6 dénidé étant placé au-dessus de la borne 14$_i$ à la suite des étapes décrites ci-dessus, on dépose une goutte G d'une résine époxy chargée en un matériau conducteur. La goutte G entoure de préférence le fil 6 et assure la liaison électrique entre le fil et la borne 14$_i$. Les moyens de mise en œuvre de ce procédé de liaison sont bien connus. On peut citer en particulier la revue »Electronic design«, 20, Septembre 27, 1975, pages 82 à 85.

Dans le cas où le pas entre les bornes des circuits A et B est inférieur à 0,5 mm, on rencontre des problèmes de positionnement de l'ensemble représenté sur la fig. 2a sur les bornes de connexion des ensembles électriques A et B qui sont pratiquement insurmontables. Pour ce type de connexion, avant de réaliser le collage du fil conducteur 6, on colle le support souple 2 sur les ensembles électriques A et B, ce support souple étant dépourvu de son fil conducteur. En d'autres termes on se retrouve dans la situation représentée sur la fig. 2b, à l'exception du fait que le support souple 2 ne comporte pas encore de fil conducteur. Selon ce mode de mise en oeuvre, après collage du support souple 2 sur les éléments A et B et à l'aide de la même machine, on procède par exemple au collage du fil 6 de façon continue comme cela a déjà été expliqué en liaison avec la fig. 2a. Lorsque la totalité de ce collage a été réalisée, on procède à l'étape illustrée sur la fig. 2c d'une façon entièrement analogue à ce qui a été décrit en liaison avec cette figure.

Il va de soi que dans le cas où le pas des bornes des ensembles A et B sont différents, la liaison avec l'un de ces ensembles peut présenter des problèmes de positionnement alors que la liaison avec l'autre ensemble n'en présente pas. Dans ce cas, bien entendu, on pourra mettre en œuvre une solution intermédiaire entre les deux modes de mise en œuvre décrits précédemment, c'est-à-dire que le support souple 2 sera collé sur l'ensemble électrique ou électronique pour lequel le pas de connexion est réduit et l'autre extrémité du support souple 2 ne sera collée sur le deuxième ensemble électrique qu'après collage du fil.

Sur la fig. 3, on a représenté en perspective un exemple de mise en œuvre du procédé objet de l'invention, au cas de la réalisation des sorties d'un imageur à cristaux liquides qui porte la référence 20. Cet imageur est fixé sur une table support 22 et il présente sur chacun de ses quatre côtés des bornes de sortie 24 qui, dans l'exemple considéré, sont au nombre de 256 avec un pas égal à 0,2 mm. On a représenté également les connexteurs 28 qui permettent de relier les différentes bornes 24 de l'imageur au circuit électrique de traitement des signaux et de commande de l'état des différents points sensibles de l'imageur. Dans le cas particulier, on trouve pour chaque face de l'imageur quatre connecteurs 28 empilés les uns sur les autres, ces connecteurs présentant chacun 64 voies et un pas de l'ordre de 2,54 mm. Chacun des connecteurs 28 est relié aux bornes 24 de l'imageur 22 par quatre ensembles 26 de support souple munis des fils de connexion. La liaison et la mise en place de ces supports souples de connexion, par rapport aux bornes de l'imageur, se fait comme indiqué précédemment. La liaison avec les bornes du connecteur se fait, par exemple, de manière classique en soudant sur ces bornes les extrémités du fil, dépassant du support souple. Dans ce cas particulier, le fil servant à la réalisation des interconnexions est isolé.

Cet exemple montre que la liaison entre les deux ensembles électriques peut être réalisée à l'aide de plusieurs supports souples indépendants comportant chacun un certain nombre de liaisons électriques.

Il montre également que le procédé de l'invention peut être mis en œuvre à l'une seulement des extrémités du support souple, pour la connexion à l'un seulement des ensembles A et B.

La description du procédé de l'invention a été faite dans le cas, courant en pratique, où les bornes des ensembles à interconnecter sont alignées; il est évident que l'invention s'applique également au cas où les bornes de l'un au moins de ces ensembles sont réparties d'une manière quelconque à la surface dudit ensemble. Les évidements rectangulaires 4a ou 4b sont alors remplacés par une pluralité d'évidements présentant la même configuration géométrique que les bornes à interconnecter, sur lesquelles le support souple vient prendre place.

## Revendications

1. Procédé de connexion de deux ensembles (A, B) présentant chacun n bornes de connexion à l'aide de liaisons conductrices (6) portées par un support isolant souple (2) ayant, au voisinage d'une au moins de ses extrémités, un évidement (4) muni d'un prolongement (7), les bornes de connexion (Ai, Bi) de l'un au moins desdits ensembles (A, B) se présentant sous forme de zones conductrices affleurant à la surface extérieure du support de cet ensemble, caractérisé en ce que:

— on réalise un support souple isolant (2) ayant deux extrémités de connexion (2a, 2b) raccordés par une partie centrale (2c) de largeur réduite et dont le ou les évidements (4a, 4b) sont conçus pour se superposer aux bornes alignées (Ai, Bi) de l'ensemble (A, B) correspondant;

— on déroule et on colle un fil conducteur (6) de façon continue sur le support souple (2) de manière à former un serpentin comportant des boucles (6'a, 6b) disposées sur des prolongements (7a, 7b) au-delà desdits évidements (4a, 4b);

— on assure la liaison électrique entre chacune des bornes (Ai, Bi) et chacune des portions de fil (6) disposées au-dessus desdits évidements (4a, 4b) en regard l'une de l'autre;

— on coupe les prolongements (7a, 7b) et on enlève lesdites boucles (6'a, 6b);

— ledit procédé comportant, en outre, l'étape de coller lesdites extrémités (2a, 2b) du support souple (2) sur les ensembles (A, B).

2. Procédé selon la revendication 1, caractérisé en ce que le pas des bornes de connexion étant supérieur à 0,5 mm, on colle d'abord lesdites liaisons électriques (6) sur ledit support souple (2) et en ce qu'ensuite, on colle les extrémités (2a, 2b) dudit support souple (2) sur les supports desdits ensembles (A, B).

3. Procédé selon la revendication 1, caractérisé en ce que le pas des bornes de connexion étant inférieur à 0,5 mm, on colle d'abord les extrémités du support souple (2) sur les supports desdits ensembles (A, B) de telle façon que le ou lesdits évidements (4a, 4b) soient disposés au droit desdites bornes (Ai, Bi) et en ce qu'ensuite, on colle lesdites liaisons électriques (6) sur ledit support souple (2).

4. Procédé selon la revendication 1, caractérisé en ce que le pas des bornes de connexion d'un des ensembles (A, B) étant inférieur à 0,5 mm, l'autre étant supérieur à 0,5 mm, on colle d'abord une des extrémités (2a, 2b) de connexion du support souple (2) sur le support de l'ensemble présentant le plus petit pas de telle façon que l'évidement correspondant (4a, 4b) se superpose aux bornes (Ai, Bi) dudit ensemble, en ce que l'on colle ensuite les liaisons électriques (6) sur ledit support souple (2) puis, en ce que l'on colle la deuxième extrémité (2a, 2b) dudit support souple ainsi pourvu de liaisons électriques sur le support de l'ensemble présentant le plus grand pas de telle façon que l'évidement correspondant (4a, 4b) se superpose alors à cet ensemble.

5. Procédé selon la revendication 1, caractérisé en ce que le fil conducteur est isolé et en ce qu'on le dénude au droit desdits évidements.

6. Procédé selon la revendication 1, caractérisé en ce que le fil conducteur n'est pas isolé.

7. Procédé selon l'une au moins des revendications 1 à 6, caractérisé en ce qu'on répartit les n liaisons électriques sur une pluralité de supports isolants souples, les bornes de l'un des ensembles à connecter étant réparties sur une pluralité de sous-ensembles liés chacun à l'un des supports isolants souples.

## Patentansprüche

1. Verfahren zur Verbindung von zwei Anordnungen (A, B), von denen jede n Verbindungsstifte aufweist, mit Hife von leitenden Verbindungen (6), die von einem biegsamen, isolierenden Träger (2) getragen werden, der in der Nähe von wenigstens einem seiner Enden eine mit einer Verlängerung (7) versehene Ausnehmung (4) aufweist, wobei die Verbindungsstifte (Ai, Bi) von wenigstens einer dieser Anordnungen (A, B) in der Form von leitenden Bereichen vorliegen, die an der äußeren Oberfläche des Trägers dieser Anordnung freiliegen, dadurch gekennzeichnet,

daß ein biegsamer, isolierender Träger (2) mit zwei Verbindungsenden (2a, 2b), die durch einen mittleren Teil (2c) geringerer Breite miteinander verbunden sind, hergestellt wird, wobei dessen Ausnehmung(en) (4a, 4b) ausgebildet werden, um sich den ausgerichteten Stiften (Ai, Bi) der entsprechenden Anordnung (A, B) zu überlagern,

daß man einen Leitungsdraht (6) abwickelt und ihn fortlaufend auf den biegsamen Träger (2) derart klebt, daß eine Schlangenlinie gebildet wird, welche Schlaufen (6'a, 6b) aufweist, die auf den Verlängerungen (7a, 7b) jenseits der Ausnehmungen (4a, 4b) angeordnet sind, daß eine wechselseitige, elektrische Verbindung zwischen jedem der Stifte (Ai, Bi) und jedem der über den Ausnehmungen (4a, 4b) angeordneten Abschnitte des Drahtes (6) sichergestellt wird, daß die Verlängerungen (7a, 7b) abgeschnitten und die Schlaufen (6a', 6b) entfernt werden, und daß dieses Verfahren ferner den Schritt umfaßt, bei dem die Enden (2a, 2b) des biegsamen Trägers (2) auf die Anordnungen (A, B) geklebt werden.

2. Verfahren nach Anspruch 1, dadurch gekennzeichnet, daß, wenn die Teilung zwischen den Verbindungsstiften größer als 0,5 mm ist, zuerst die elektrischen Verbindungen (6) auf den biegsamen Träger (2) geklebt werden und daß anschließend die Enden (2a, 2b) des biegsamen Trägers (2) auf die Träger der Anordnungen (A, B) geklebt werden.

3. Verfahren nach Anspruch 1, dadurch gekennzeichnet, daß, wenn die Teilung zwischen den Verbindungsstiften kleiner als 0,5 mm ist, zunächst die Enden des biegsamen Trägers (2) auf die Träger der Anordnungen (A, B) derart geklebt werden, daß die Ausnehmung(en) (4a, 4b) senkrecht zu den Stiften (Ai, Bi) angeordnet sind, und daß man anschließend die elektrischen Verbindungen (6) auf den biegsamen Träger (2) klebt.

4. Verfahren nach Anspruch 1, dadurch gekennzeichnet, daß, wenn die Teilung zwischen den Verbindungsstiften einer der Anordnungen (A, B) kleiner als 0,5 mm und die andere größer als 0,5 mm ist, zunächst eines der Verbindungsenden (2a, 2b) des biegsamen Trägers (2) auf den Träger der Anordnung, welche die kleinere Teilung aufweist, derart geklebt wird, daß sich die entsprechende Ausnehmung (4a, 4b) den Stiften (Ai, Bi) der genannten Anordnung überlagert, daß anschließend die elektrischen Verbindungen (6) auf den biegsamen Träger (2) geklebt werden, woraufhin das zweite Ende (2a, 2b) des biegsamen Trägers, das somit mit den elektrischen Verbindungen versehen ist, derart auf den Träger der Anordnung, welche die größere Teilung aufweist, geklebt wird, daß sich die entsprechende Ausnehmung (4a, 4b) dann dieser Anordnung überlagert.

5. Verfahren nach Anspruch 1, dadurch gekennzeichnet, daß der Leitungsdraht isoliert ist und daß man ihn längs dieser Ausnehmungen freilegt.

6. Verfahren nach Anspruch 1, dadurch gekennzeichnet, daß der Leitungsdraht nicht isoliert ist.

7. Verfahren nach mindestens einem der Ansprüche 1 bis 6, dadurch gekennzeichnet, daß man die n elektrischen Verbindungen auf eine Vielzahl von biegsamen, isolierenden Trägern aufteilt, wobei die Stifte einer der zu verbindenden Anordnungen auf eine Vielzahl von Unteranordnungen aufgeteilt werden, von denen jede mit einem der biegsamen, isolierenden Träger verbunden ist.

**Claims**

1. Method of connecting two assemblies (A, B) each having n terminals by conducitve connections (6)mounted on a flexible insulating support (2) having near at least one of its ends a hollow (4) and an extension (7), the terminals (Ai, Bi) of at least one of the assemblies (A, B) being in the form of conducitve zones flush with the external surface of the support of that assembly, characterized by
providing a flexible insulating support (2) having two connecting ends (2a, 2b) joined by a central portion (2c) of smaller size and in which the hollow or hollows (4a, 4b) are formed to be superimposed upon aligned terminals (Ai, Bi) of the corresponding assemblies (A, B);
laying down and sticking on the flexible support (2) a continuous conducting wire (6) in a boustro edal pattern having loops (6'a, 6b) disposeo on the extensions (7a, 7b) beyond the hollows (4a, 4b);
ensuring electrical contact between each of the terminals (Ai, Bi) and corresponding portions of wire (6) extending beyond the hollows (4a, 4b);
cutting off the extensions (7a, 7b) and removing the loops (6'a, 6b);
which method also includes the step of sticking the ends (2a, 2b) of the flexible support (2) on the assemblies (A, B).

2. Method according to Claim 1 characterized in that the distance between the terminals is greater than 0.5 mm and that the electrical connection (6) is first stuck to the flexible support (2) and that the ends (2a, 2b) of the flexible support (2) are then stuck on the supports of the assemblies (A, B).

3. Method according to Claim 1 characterized in that the distance between the terminals is less than 0.5 mm and that the ends of the flexible support (2) are stuck on the assemblies (A, B) so that the hollow or hollows (4a, 4b) are disposed on the terminals (Ai, Bi) and then the electrical connection (6) is stuck on the flexible support (2).

4. Method according to Claim 1 characterized in that the distance between the terminals is less than 0.5 mm for one of the assemblies (A, B) and more than 0.5 mm for the other, and first one of the ends (2a, 2b) of the flexible support (2) is stuck on the support of the assembly having the smaller distance between terminals so that the corresponding hollow (4a, 4b) is superimposed on the terminals (Ai, Bi) of the said assembly, the electrical connection (6) is then stuck on the flexible support (2), and the second end (2a, 2b) of the support, thus provided with electrical connectors, is then stuck on the support of the assembly having the greater distance between terminals, so that the corresponding hollow (4a, 4b) is thus superimposed on the terminals of that assembly.

5. Method according to Claim 1 characterized in that the conducting wire is insulated and is stripped at the hollows.

6. Method according to Claim 1 characterized in that the conducting wire is not insulated.

7. Method according so at least one of Claims 1 to 6 characterized in that the n connections are distributed over a plurality of flexible insulating supports, the terminals of one of the assemblies being distributed in a plurality of sub-assemblies, each linked to one of the flexible insulating supports.

# FIG.1

# FIG.2

FIG.3

20

26

24

28

22

FIG.4

6 G 14i

A